Europäisches Patentamt

European Patent Office

Office européen des brevets

(11) Veröffentlichungsnummer: **0 279 949**
A1

# EUROPÄISCHE PATENTANMELDUNG

(21) Anmeldenummer: 87119243.1

(22) Anmeldetag: 28.12.87

(51) Int. Cl.⁴: **H01L 21/304** , B24B 7/00

(30) Priorität: 11.02.87 CH 506/87

(43) Veröffentlichungstag der Anmeldung:
**31.08.88 Patentblatt 88/35**

(84) Benannte Vertragsstaaten:
**BE CH DE FR GB IT LI SE**

(71) Anmelder: **BBC Brown Boveri AG**
**Haselstrasse**
**CH-5401 Baden(CH)**

(72) Erfinder: **Dlouhy, Jiri**
**Haldenstrasse 410**
**CH-5506 Mägenwil(CH)**
Erfinder: **Kuhn, Otto**
**Weierstrasse 260**
**CH-5242 Lupfig(CH)**

(54) **Verfahren zur Herstellung von Halbleiterbauelementen.**

(57) Bei einem Verfahren zur Herstellung von Halbleiterbauelementen, insbesondere für höhere Leistungen, wird aus einem Wafer (1) wenigstens ein kreisrundes Bauelementsubstrat (2) kleinerer Fläche mit einem Hohlbohrer (4) herausgetrennt.

Gemäss einer bevorzugten Ausführung wird ein Hohlbohrer (4) mit einer geneigten innenseitigen Bohrkronenflanke (8) verwendet, so dass zugleich mit dem Ausbohren des Elementes die für bestimmte Bauelemente mit höherer Sperrspannung notwendige Randabschrägung angebracht wird.

FIG.4

EP 0 279 949 A1

# VERFAHREN ZUR HERSTELLUNG VON HALBLEITERBAUELEMENTEN

## TECHNISCHES GEBIET

Die Erfindung bezieht sich auf die Herstellung von Halbleiterbauelementen. Insbesondere betrifft sie ein Verfahren zur Herstellung von Halbleiterbauelementen für höhere Leistungen, wobei aus einem Wafer mechanisch wenigstens ein Bauelementsubstrat kleinerer Fläche herausgetrennt wird.

## STAND DER TECHNIK

Ausgangspunkt bei der Herstellung von Halbleiterbauelementen bildet, sowohl für integrierte Schaltungen als auch für Leistungshalbleiter, der Wafer. Dies ist eine dünne Einkristallscheibe, welche beispielsweise durch Zersägen eines aus der Schmelze gezogenen Einkristalls gewonnen wird. In der Praxis wird als Wafermaterial vorwiegend Silizium verwendet.

Indem der Wafer einer Reihe von geeignet ausgestalteten Heissprozessen unterworfen wird, erzeugt man die Dotierungsstrukturen, welche dem herzustellenden Element die gewünschten elektrischen Eigenschaften geben.

Ein wichtiger Produktionsschritt, welcher bisher vorwiegend bei der Herstellung der integrierten Schaltungen zur Anwendung gelangte, ist das Zerteilen eines Wafers, in welchen eine Vielzahl von identischen Bauelementstrukturen eingebracht worden ist, in die entsprechenden Bauelemente. Dies erfolgt auf chemische und/oder mechanische Weise entlang vordefinierter Linien.

Die Anwendung dieser sogenannten Zerteiltechnik erlaubt eine optimale Nutzung von Material und Zeit.

Bis anhin wurde die Zerteiltechnik bei der Herstellung von Leistungshalbleiterbauelementen nicht angewendet, da die Fläche der angebotenen Wafer nie wesentlich grösser als diejenige der herzustellenden Bauelemente war. Aus diesem Grund wurden die Wafer so eingekauft, dass sie in ihrer Grösse in etwa derjenigen des fertigen Bauelementes entsprachen. Im Verlauf einer den Herstellungsprozess abschliessenden Randbehandlung erhielten sie dann ihre endgültige Abmessung.

Neuerdings sind nun Wafergrössen im Handel erhältlich, die die Anwendung der Zerteiltechnik möglich machen.

Für das Zerteilen eines Wafers sind in der Vergangenheit verschiedene Methoden vorgeschlagen worden.

Wohlbekannt ist ein Verfahren, bei welchem mit einem geeigneten Werkzeug (z.B. mit einer Diamantnadel) der Wafer, entsprechend der Anordnung der Bauelemente, gitterförmig geritzt wird, so dass er unter der nachfolgend angebrachten, mechanischen Spannung entlang der geritzten Linien bricht.

Der Nachteil dieses Verfahrens liegt darin, dass man wegen der Wirkungsweise der anzubringenden mechanischen Spannung auf gerade Bruchlinien beschränkt ist.

In der US-PS 3,694,972 wird ein Sandstrahlverfahren vorgestellt, welches grundsätzlich erlaubt, beliebig vorgebbare Formen aus einem Wafer herauszutrennen. Der Kern jener Erfindung ist eine speziell ausgeformte Maske, welche den ganzen Wafer überdeckt, und welche ein geeignetes Kanalmuster aufweist, dergestalt, dass der Wafer unter dem Einfluss der durch die Maske durchgeblasenen Sandstrahlen in die gewünschten Teilbereiche geschnitten wird.

Da Sandstrahlanlagen bekanntermassen wartungsintensiv sind, und da der Zeitaufwand zum Durchtrennen von Wafern mit einer Dicke in der Grössenordnung von 1000 $\mu$m, wie sie insbesondere bei der Herstellung von Leistungshalbleiterbauelementen Verwendung finden, jenseits der Grenze des Tolerierbaren liegt, muss in der Leistungshalbleiterproduktion nach neuen Lösungen gesucht werden.

Ein zusätzlicher Aspekt, dem in der Produktion der integrierten Schaltungen untergeordnete Bedeutung zukommt, dem dagegen bei der Herstellung von Leistungshalbleiterbauelementen erhöhte Aufmerksamkeit geschenkt werden muss, ist die Qualität der Kristallstruktur am Rand des Elements. Ihm soll im gesuchten Verfahren entsprechend Rechnung getragen werden.

## DARSTELLUNG DER ERFINDUNG

Aufgabe der vorliegenden Erfindung ist es daher, ein Verfahren zum mechanischen Heraustrennen von Bauelementsubstraten aus Wafern zu schaffen, welches mit geringem apparativem Aufwand realisierbar, schonend für die Kristallstruktur am Rand des Bauelementsubstrates und zeitökonomisch ist.

Die Aufgabe wird bei einem Verfahren der eingangs genannten Art so gelöst, dass das Bauelementsubstrat kreisrund ist und mittels eines Hohlbohrers aus dem Wafer herausgetrennt wird.

Das erfindungsgemässe Verfahren ermöglicht es, Teilbereiche einfach, schnell und schonend für die Kristallstruktur aus einem Wafer, insbesondere einem dicken Wafer (Grössenordnung 1000 $\mu$m),

herauszutrennen.

Gemäss einem bevorzugten Ausführungsbeispiel der Erfindung wird ein Hohlbohrer verwendet, dessen Bohrkrone an der Innenseite eine schräge Flanke aufweist. Auf diese Weise kann gleichzeitig mit dem Ausbohren die bei Bauelementen mit höherer Sperrspannung notwendige Randabschrägung angebracht werden.


KURZE BESCHREIBUNG DER ZEICHNUNGEN

Die Erfindung soll nachfolgend im Zusammenhang mit den Zeichnungen anhand von Ausführungsbeispielen näher erläutert werden. Es zeigen:

Fig. 1 die Hauptfläche eines Wafers, aus welchem Bauelementsubstrate unterschiedlicher Grösse herausgetrennt werden,

Fig. 2 die Hauptfläche eines Bauelementsubstrates, dessen Rand abgebohrt werden soll,

Fig. 3 den Querschnitt durch einen Hohlbohrer beim Heraustrennen des Bauelementsubstrates aus dem Wafer, und

Fig. 4 den Querschnitt durch einen Hohlbohrer mit einer schrägen Bohrkronenflanke beim Heraustrennen des Bauelementsubstrates aus dem Wafer.


WEGE ZUR AUSFÜHRUNG DER ERFINDUNG

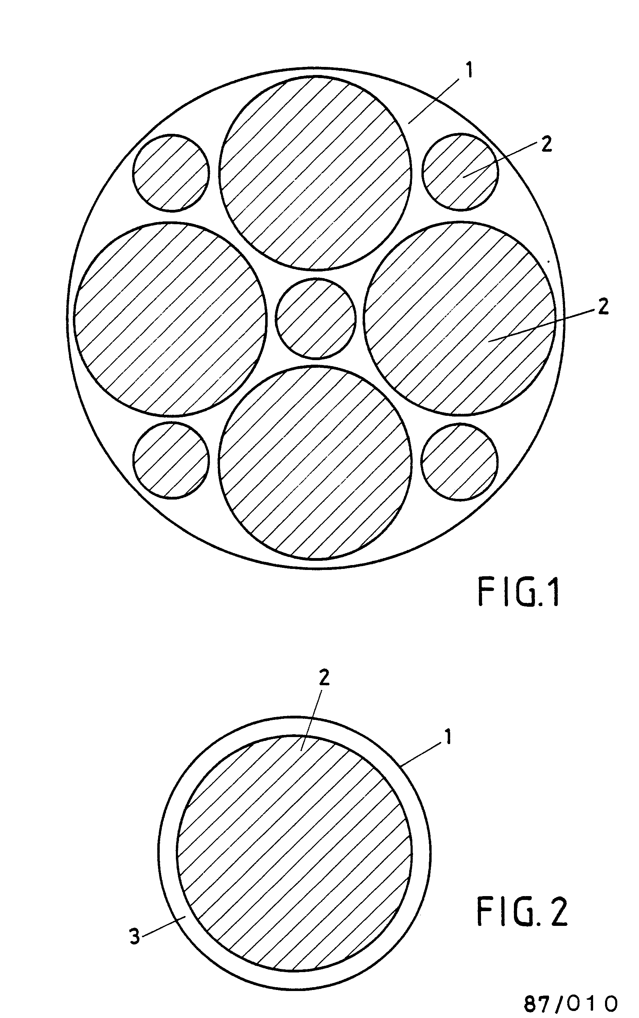

Ein erstes Beispiel (Fig. 1) zeigt eine bevorzugte Ausführung des erfindungsgemässen Verfahrens in der Anwendung auf die Zerteiltechnik bei der Produktion von Leistungshalbleiterbauelementen.

Ausgangspunkt ist vorzugsweise ein fertig diffundierter, runder Wafer 1, welcher üblicherweise einen Durchmesser von mehreren cm und eine Dicke in der Grössenordnung von 1000 $\mu$m aufweist. Aus dem Wafer 1 sollen, wie in Fig. 1 - schematisch dargestellt, runde Bauelementsubstrate 2, welche jeweils die Dotierungsstruktur des gewünschten Elementes aufweisen, herausgetrennt werden.

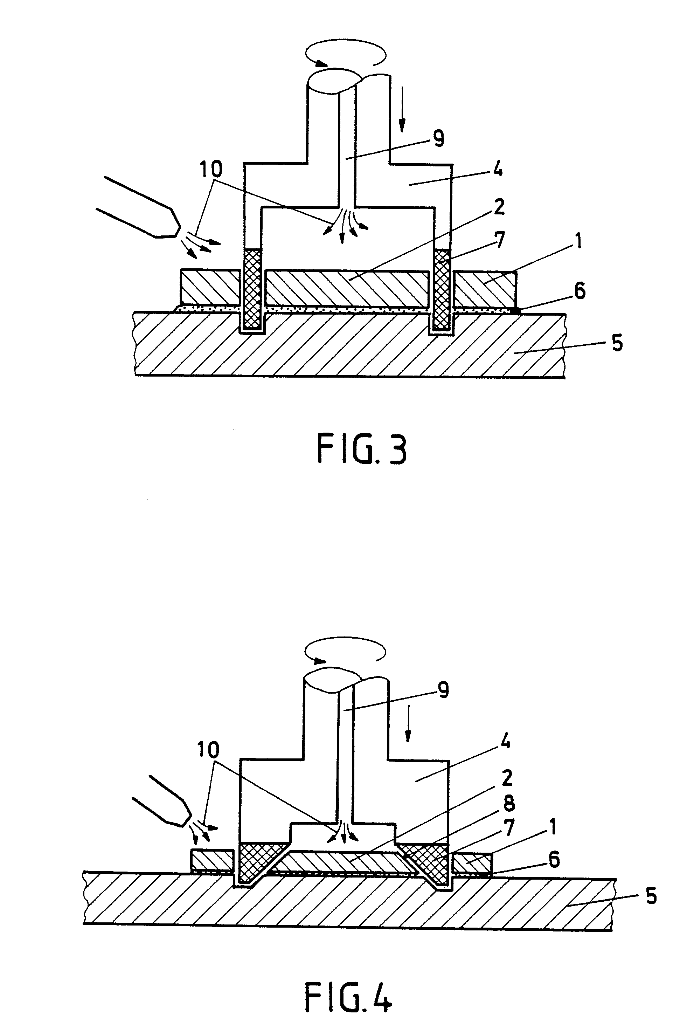

Dabei wird vorzugsweise wie folgt vorgegangen (Fig. 3):

In einem ersten Schritt wird der Wafer 1 auf einer ebenen Unterlagsplatte 5 fixiert, worauf in einem zweiten Schritt ein gewünschtes Bauelementsubstrat 2 mit einem Hohlbohrer 4 aus dem Wafer 1 herausgebohrt wird.

In der Praxis kann der Wafer 1 beispielsweise mit einem schnellhärtenden Klebstoff 6 auf eine als Unterlagsplatte dienende Glasplatte geklebt werden. Zum Ausbohren hat sich bei dieser speziellen Konstellation beim Hohlbohrer 4 eine Bohrkrone 7 mit einem Diamantbelag in Metallbindung, mit einer Körnung von 25 $\mu$m und einer Konzentration von 100 (4.4 ct/cm$^3$) bewährt. Des weiteren kann bei den oben genannten Bohrerkenngrössen für den durch den Pfeil angedeuteten Vorschub des Hohlbohrers 4 eine Geschwindigkeit von 1 - 2 mm/min empfohlen werden, welche durch die Tangentialgeschwindigkeit der Bohrkrone 7 von etwa 7 m/s gerechtfertigt ist.

Während des Bohrens wird die Bohrkrone 7 von aussen und von innen durch ein Kühlmittel 10 gekühlt. Die innenseitige Kühlmittelzufuhr wird durch einen Kühlmittelzufuhrkanal 9 ermöglicht.

Für den oben beschriebenen Hohlbohrer 4 ist in der genannten Anordnung als Kühlmittel 10 Wasser mit einem Rostschutzmittelzusatz verwendet worden, um den metallgebundenen Diamantbelag der Bohrkrone 9 vor Korrosion zu schützen.

Es versteht sich von selbst, dass Schnittgeschwindigkeit und Bohrervorschub auf den Belag der Bohrkrone 7 abgestimmt sein müssen, welcher Belag wiederum vom Material des Wafers 1 und der ebenen Unterlagsplatte 5 abhängt. Die oben genannte Parameterwerte haben also bloss Beispielcharakter.

Ein zweites Ausführungsbeispiel behandelt das Abbohren des Randes eines einzelnen Bauelementes.

Die Grenzflächen eines Wafers, welche naturgemäss eine Störung der Kristallsymmetrie der angrenzenden Kristallzonen darstellen, beeinflussen die in den Heissprozessen erzeugten Dotierungsprofile stets in einer unkontrollierbaren Art. Aus diesem Grund bilden die Ränder von Leistungshalbleiterbauelementen besonders störanfällige Gebiete, und werden deshalb in einer abschliessenden Behandlung entfernt. Für solche einzelne Bauelemente ergibt sich die Möglichkeit, das erfindungsgemässe Verfahren anzuwenden.

Fig. 2 stellt die Hauptfläche eines fertig diffundierten Wafers 1 dar. Von ihm soll ein Bauelementrand 3 abgebohrt werden, um das einzelne Bauelementsubstrat 2 zu erhalten. Wie im ersten Ausführungsbeispiel (Fig. 3) wird der Wafer 1 mit einem Klebstoff 6 auf eine Glasplatte geklebt und dann mit einem Hohlbohrer 4 ausgebohrt. Die Kenngrössen des Bohrers und der Bohrkrone, sowie der Bohrervorschub und die Schnittgeschwindigkeit können dieselben sein wie im ersten Ausführungsbeispiel.

Das Ausbohren des Bauelementrandes 3 wurde für Frequenzthyristoren eingehend erprobt. Es hat sich gezeigt, dass die Ausbeute an funktionstüchtigen Bauelementen gegenüber herkömmlichen Techniken um 15 % erhöht werden konnte.

Bei einer besonders bevorzugten Ausgestaltung des erfindungsgemässen Verfahrens (Fig. 4) wird eine Bohrkrone 7 mit einer schrägen innenseitigen Bohrkronenflanke 8 verwendet. Der Vorteil einer derartigen Ausgestaltung liegt darin, dass zugleich mit dem Ausbohren des Bauelementsubstrates 2 die für Elemente mit höherer Sperrspannung notwendige Abschrägung des Randes angebracht werden kann, was eine beträchtliche Verminderung des Arbeitsaufwandes bedeutet.

Fig. 4 veranschaulicht die Wirkungsweise der abgeschrägten, innenseitigen Bohrkronenflanke 8 bei der Anwendung gemäss dem zweiten Ausführungsbeispiel.

Es liegt jedoch auf der Hand, dass die besonders bevorzugte Ausgestaltung des Verfahrens sowohl beim Abbohren des defektanfälligen Randes von Leistungshalbleiterbauelementen als auch in der zuerst beschriebenen Zerteiltechnik verwendet werden kann.

Insgesamt steht mit der Erfindung ein Verfahren zum Herstellen von Halbleiterbauelementen zur Verfügung, bei welchem das Heraustrennen von kleineren Bauelementsubstraten aus einem grösseren Wafer einfach und mit geringem Zeitaufwand durchzuführen ist, und welches eine hohe Qualität der Randzonen garantiert.

**Ansprüche**

1. Verfahren zur Herstellung von Halbleiterbauelementen, insbesondere für höhere Leistungen, wobei aus einem Wafer (1) mechanisch wenigstens ein Bauelementsubstrat (2) kleinerer Fläche herausgetrennt wird, dadurch gekennzeichnet, dass das Bauelementsubstrat (2) kreisrund ist und mittels eines Hohlbohrers (4) aus dem Wafer (1) herausgetrennt wird.

2. Verfahren nach Anspruch 1, dadurch gekennzeichnet, dass aus einem Wafer (1) mehrere Bauelementsubstrate (2) gleicher und/oder unterschiedlicher Grösse herausgetrennt werden.

3. Verfahren nach Anspruch 1, dadurch gekennzeichnet, dass das Heraustrennen vorgenommen wird, nachdem der Wafer (1) allen für die Bauelementherstellung nötigen Heissprozessen unterworfen worden ist.

4. Verfahren nach Anspruch 1, dadurch gekennzeichnet, dass ein Hohlbohrer (4) mit einer Bohrkrone (7) mit schräger innenseitiger Bohrkronenflanke (8) verwendet wird, derart, dass die bei Bauelementen mit höherer Sperrspannung notwendige Randabschrägung beim Ausbohren gleichzeitig am Rand des Bauelementsubstrats (2) angebracht wird.

5. Verfahren nach Anspruch 1, dadurch gekennzeichnet, dass der Hohlbohrer (4) ein Diamantbohrer mit einer Körnung von 25 μm und einer Konzentration von 100 (4.4 ct/cm³) in Metallbindung ist.

6. Verfahren nach Anspruch 5, dadurch gekennzeichnet, dass der Hohlbohrer (4) von aussen und von innen gekühlt wird, insbesondere, dass die Kühlmittelzufuhr durch einen Kühlmittelzufuhrkanal (11) im Bohrer erfolgt.

7. Verfahren nach Anspruch 6, dadurch gekennzeichnet, dass als Kühlmittel Wasser mit einem Rostschutzmittelzusatz verwendet wird.

8. Verfahren nach Anspruch 1, dadurch gekennzeichnet, dass der Wafer (1) beim Bohren auf einer ebenen Unterlagsplatte (5) fixiert ist.

9. Verfahren nach Anspruch 8, dadurch gekennzeichnet, dass der Wafer (1) mit einem Klebestoff (6) auf einer als Unterlagsplatte dienenden Glasplatte fixiert ist.

10. Verfahren nach Anspruch 5, dadurch gekennzeichnet, dass die Schnittgeschwindigkeit an der Bohrkrone (7) etwa 7 m/s und der Vorschub des Hohlbohrers (4) 1 - 2 mm/min beträgt.

FIG.1

FIG. 2

FIG. 3

FIG. 4

87/01 0

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | GB-A-1 018 903 (SIEMENS AG)<br>* Seite 3, Zeilen 4-38; Figuren 2,3 * | 1-4,8 | H 01 L 21/304<br>B 24 B 7/00 |
| A | | 5,9 | |
| | --- | | |
| Y | EP-A-0 209 767 (SEMIKRON GmbH)<br>* Figuren 2,3; Seite 2, Zeile 5 - Seite 3, Zeile 49 * | 1-4,8 | |
| | --- | | |
| A | DE-A-1 614 554 (SEIMKRON GmbH)<br>* Figuren 1,2; Seiten 2-4 * | 1-3 | |
| | ----- | | |

| | | | RECHERCHIERTE SACHGEBIETE (Int. Cl.4) |
|---|---|---|---|
| | | | H 01 L<br>B 24 B |

Der vorliegende Recherchenbericht wurde für alle Patentansprüche erstellt

| Recherchenort | Abschlußdatum der Recherche | Prüfer |
|---|---|---|
| DEN HAAG | 20-05-1988 | GELEBART J.F.M. |